# EUROPEAN PATENT SPECIFICATION

(11) **EP 4 079 678 B1**
(45) Date of publication and mention of the grant of the patent: **21.10.2026**
(21) Application number: 22158410.5
(22) Date of filing: 24.02.2022
(51) Int. Cl.: B81B 3/00

(54) **MEMS ROTOR WITH COATED BOTTOM SURFACE**
MEMS-ROTOR MIT BESCHICHTETER UNTERSEITE
ROTOR MEMS À SURFACE INFÉRIEURE REVÊTUE

(30) Priority: 22.04.2021 FI 20215470
(43) Date of publication of application: 26.10.2022
(73) Proprietor: Murata Manufacturing Co., Ltd., Nagaokakyo-shi, Kyoto 617-8555 (JP)
(72) Inventor: Kilpinen, Petteri, 02620 Espoo (FI)
(74) Representative: Boco IP Oy Ab

(56) References cited:
- US-A1- 2005 046 504
- US-A1- 2008 018 975
- US-A1- 2016 332 864
- "Introduction to Microfabrication", 25 October 2010, JOHN WILEY & SONS, ISBN: 978-0-470-66672-2, article FRANSSILA SAMI: "Introduction to Microfabrication", pages: 60 - 60, XP093264647

## Description

### FIELD OF THE DISCLOSURE

This disclosure relates to micromechanical devices, and particularly to micromechanical devices formed in a device wafer which is bonded to a handle wafer. The present disclosure further concerns the mass of a mobile rotor formed in the device wafer.

### BACKGROUND OF THE DISCLOSURE

Microelectromechanical (MEMS) devices are typically manufactured from silicon substrates. The micromechanical structures may be formed in a device wafer which has been bonded to a thicker handle wafer for structural support. The micromechanical structures often include a rotor which is mobile in relation to the fixed parts of the device wafer. A cavity can be formed in the region of the handle wafer which will lie beneath the rotor.

The formation of microelectromechanical structures in the device wafer usually requires gaps which are etched all the way through the device wafer. The deep-etch processes by which such gaps are produced will often leave structural irregularities in these gaps if the device wafer is thick. The likelihood of irregularities will be lower - and the yield of the manufacturing process will consequently be better - if the device wafer is thinner.

However, very thin device wafers can lead to other challenges in devices such as accelerometers and gyroscopes, where an output signal is produced by measuring the movement of a rotor which has been etched in the device wafer. The output signal becomes more sensitive to small fluctuations in the surrounding environment if the device wafer is very thin and the rotor has a very small mass.

A rotor with greater surface area will be heavier, but it is typically not a good solution to increase the weight of the rotor by increasing its surface area. The increased area required will also lead to a lower yield when less MEMS chips fit on one device wafer. It would be preferable to use a thin device wafer with a sufficiently heavy rotor without having to increase the surface area of the MEMS chip.

Document US 2008/018975 A1 discloses a micro-mirror with a honeycomb structure sandwiched between two solid and smooth silicon layers without any indentations or holes. US 2016/332864 A1 relates to inertial sensors comprising a device wafer bonded to a handle wafer.

### BRIEF DESCRIPTION OF THE INVENTION

An object of the present invention is to provide an apparatus and method which overcome the above problems.

The object of the invention is achieved by a method and a MEMS component as specified in the independent claims. The preferred embodiments of the invention are disclosed in the dependent claims.

The invention is based on the idea of depositing an additional layer on the surface of a rotor in a device wafer before the device wafer is bonded to a handle wafer. This increases the mass of the rotor. An advantage of this arrangement is that a very thin device wafer can be used.

### BRIEF DESCRIPTION OF THE DRAWINGS

In the following the invention will be described in greater detail by means of preferred embodiments with reference to the accompanying drawings, in which
Figures 1a - 1c illustrate a MEMS component where the bottom surface of the rotor is coated, and a method for manufacturing such a component.
Figure 1d illustrates a bottom coating layer which covers a symmetric middle area on the rotor bottom surface.
Figure 2 illustrates illustrate a MEMS component where both the top and the bottom surfaces of the rotor are coated.
Figures 3a - 3b illustrate a suspension arrangement.

### DETAILED DESCRIPTION OF THE INVENTION

This disclosure relates to a method for manufacturing a MEMS component. The method comprises the steps of (1) forming a cavity on a top surface of a silicon handle wafer, (2) bonding a bottom surface of a silicon device wafer onto the top surface of the handle wafer so that the device wafer covers the cavity, and (3) forming microelectromechanical structures comprising a fixed stator part and a mobile rotor part in the device wafer. The mobile rotor part has a rotor bottom surface and a rotor top surface. The mobile rotor part is suspended from the fixed stator part above the cavity. The method also comprises the step of depositing a bottom coating layer on at least a part of the rotor bottom surface before the device wafer is bonded to the handle wafer.

In this disclosure, the surfaces of the device wafer and the handle wafer define an xy-plane which may be referred to as the device plane. The direction which is perpendicular to the device plane is illustrated with the z-axis and referred to as the vertical direction. Words such as "top" and "bottom" refer to vertically separated sides. These words do not imply anything about how the MEMS device should be oriented during usage or during manufacturing. The word "thickness" refers in this disclosure to the z-dimension.

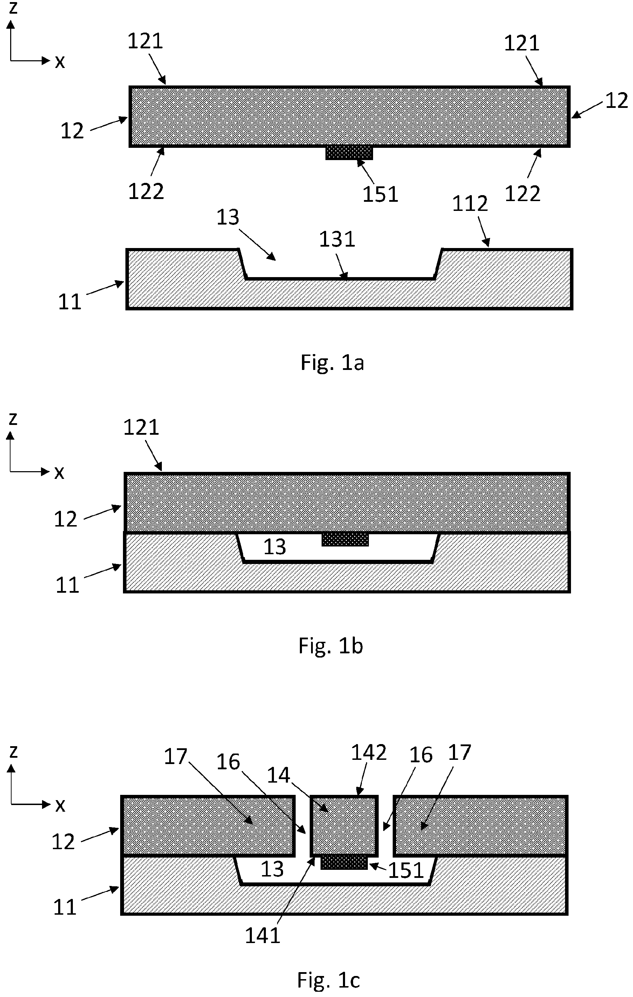

Figures 1a - 1c illustrate the method. The figure illustrates a handle wafer 11 and a device wafer 12. These two wafers may be prepared separately before they are bonded together. The handle wafer 11 has a top surface 112. A cavity 13 is prepared on the top side of the handle wafer by etching. The cavity 13 then has a cavity floor 131 which forms the bottom of the cavity.

The device wafer 12 has a top surface and a bottom surface 122. A bottom coating layer 151 is deposited on the bottom surface 122 of the device wafer 12. This bottom coating layer 151 is positioned so that it is located in a region of the bottom surface 122 which will, in a later stage of the manufacturing process, form the bottom surface of the rotor.

In the next method step, illustrated in figure 1b, the bottom surface of the device wafer 12 is bonded to the top surface of the handle wafer 11, for example by fusion bonding. The part of the device wafer 12 which comprises the bottom coating layer 151 is aligned with the cavity 13 in the handle wafer 11. Alignment marks may be implemented on the handle wafer and the device wafer to achieve good alignment.

Figure 1c illustrates the third step of the manufacturing method. Gaps such as 16 are etched in the device wafer 12 to separate the rotor part 14, which will be mobile, from adjacent stator parts in the device wafer, such as 17, whose positions are fixed in relation to the handle wafer. In practice, the rotor part 14 may be suspended from the stator parts 17 with flexible suspenders which allow the rotor part to undergo movement when it is affected by a force. Suspenders are not illustrated in figure 1c.

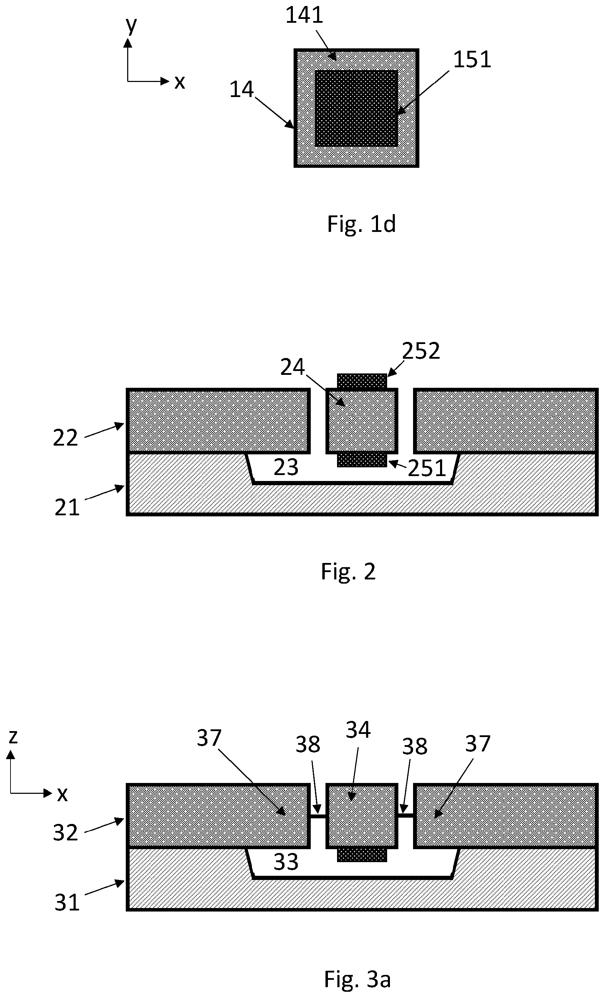

The rotor part 14 has a rotor bottom surface 141 and a rotor top surface 142. As explained above and illustrated in figure 1c, the bottom coating layer 151 was deposited in the region of the device wafer 12 which now forms at least a part of the rotor bottom surface 141. The bottom coating layer 151 may cover substantially the entire rotor bottom surface 141. Alternatively, as illustrated in figure 1d, the bottom coating layer 151 may cover a middle area on the rotor bottom surface 141, so that the layer 151 is not present on the edges of the rotor bottom surface 141. The middle area may be symmetric with respect to the center of gravity of the rotor in the xy-plane.

The material of the bottom coating layer 151 may for example be gold, copper, silver, tungsten, tantalum, yttrium, neodymium, cerium, lanthanum, zirconium, indium, niobium, molybdenum or hafnium. This material may alternatively be a carbide of tungsten, tantalum, yttrium, neodymium, cerium, lanthanum, zirconium, indium, niobium, molybdenum or hafnium, for example WC, TaCₓ, where x is between 0.4 and 1, YC₂, NdC₂, CeC₂, CeC₂, ZrC, NbC, Nb₂C, MoC, Mo₂C, or HfC. As a further alternative, the material of the bottom coating layer may be a nitride of tungsten, tantalum, yttrium, neodymium, cerium, lanthanum, zirconium, indium, niobium, molybdenum or hafnium, for example WN, WN₂, TaN or HfN. Finally, the material of the bottom coating layer may be an oxide of tungsten, tantalum or yttrium, for example WO₃, T12O₅ or Y₂O₃. It could alternatively be a nitride-carbide, oxide-carbide or nitride-oxide composite of any element listed above, or a compound material which comprises two or more of the materials listed above. These material options apply to all coating layers (top and bottom) described in this disclosure. The density of the material of the bottom coating layer 151 may be greater than the density of silicon. The density of the material of the bottom coating layer 151 may for example be in the range 5 - 50 g/cm³, 10 - 50 g/cm³ or 15 - 30 g/cm³. According to the invention, the density of the material in coating layer 151 is greater than 5 g/cm3. It may be greater than 10 g/cm³, greater than 15 g/cm³, greater than 20 g/cm³ or greater than 30 g/cm³. The thickness of the bottom coating layer 151 in the vertical direction may for example be in the range 50 nm - 50 µm, 500nm - 50 µm, 1 - 50 µm, 1 - 10 µm, 1 - 20 µm, 10 - 50 µm, 10 - 30 µm or 20 - 50 µm. The thickness of the coating layer 151 may alternatively be greater than 50 nm, greater than 500 nm, greater than 1 µm, greater than 10 µm, greater than 25 µm or greater than 50 µm. These density and thickness options apply to all coating layers (top and bottom) described in this disclosure. Any thickness option listed above can be combined with any density option listed above. Any thickness option listed above can also be combined with any material option listed above.

This disclosure also describes a MEMS component comprising a silicon handle wafer 11 with a top surface 112 which defines a horizontal plane. The top surface 112 also defines a vertical direction which is perpendicular to the horizontal plane. The MEMS component further comprises a silicon device wafer 12 with a bottom surface 122 and a top surface 121.

The handle wafer 11 comprises a cavity 13 which is delimited by a cavity floor 131 which is recessed in the vertical direction from the top surface 112 of the handle wafer 11. The device wafer 12 comprises a fixed stator part 17 and a mobile rotor part 14. The mobile rotor part 14 has a rotor bottom surface 141 and a rotor top surface 142. The mobile rotor 14 part is above the cavity floor 131. The MEMS component comprises a bottom coating layer 151 which covers at least a part of the rotor bottom surface 141.

According to the invention the MEMS component is an accelerometer or a gyroscope.

The method described above may also comprise the further step of depositing a top coating layer on at least a part of the rotor top surface. Correspondingly, the MEMS component may comprise a top coating layer which covers at least a part of the rotor top surface.

Figure 2 illustrates a component where reference number 21 - 24 and 251 correspond to reference numbers 11 - 14 and 151, respectively, in figures 1a - 1d. A top coating layer 252 has been deposited on the top surface of the rotor 24. The top coating layer 252 may be deposited on the device wafer 22 before the device wafer 22 is bonded to the handle wafer 21, or it may be deposited on the device wafer 22 after the device wafer 22 has been bonded to the handle wafer 21. The density of the top coating layer may be greater than the density of the of silicon.

It will in some cases be beneficial to make the top coating layer symmetric with the bottom coating layer. The center of gravity of the rotor part after the top and bottom coating layers have been deposited may be in the same position where the center of gravity of the rotor part had been if no bottom coating layer and no top coating layer had been deposited on the rotor part.

The material of the bottom coating layer may be the same as the material of the top coating layer. Furthermore, the vertical thickness of the top coating layer may be substantially equal to the vertical thickness of the bottom coating layer. And finally, the area covered by the bottom coating layer on the rotor bottom surface may be substantially aligned in the vertical direction with the area covered by the top coating layer on the rotor top surface.

Any material option listed above for the bottom coating layer can be applied also in the top coating layer. The material of the top coating layer may be different from the material of the bottom coating layer. Furthermore, any density option listed above for the material of the bottom coating layer may apply also to the material of the top coating layer. The density of the top coating layer may be different from the density of the bottom coating layer. Finally, any thickness option listed above for the bottom coating layer may apply also to the top coating layer. The thickness of the top coating layer may be different from the thickness of the bottom coating layer.

Figures 3a - 3b illustrate a component where reference numbers 31 - 34 and 37 correspond to reference numbers 11 - 14 and 37, respectively, in figures 1a - 1d. The embodiment shown in figures 3a - 3b can also be implemented with the top coating layer which figure 2 illustrates.

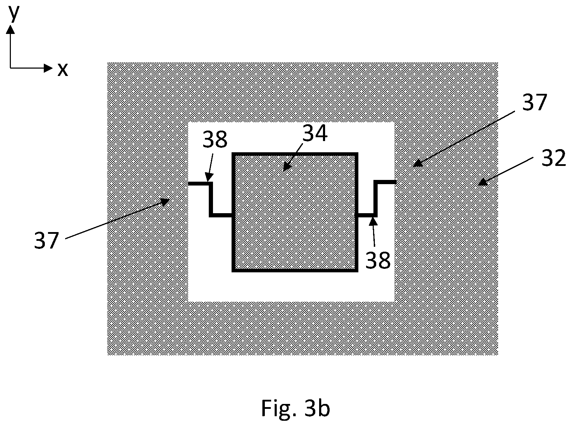

Figures 3a and 3b illustrate a suspension arrangement. The rotor part 34 is suspended from stator parts 37 by flexible suspenders 38 which extend from the rotor part to the stator part. The suspenders 38 allow the rotor part 34 to move in relation to the stator parts 37, which in this case means motion in relation to the device wafer 32. The flexible suspenders may extend from the rotor part to the stator part on at least two sides of the rotor part. These at least two sides may comprise two opposite sides of the rotor, as figures 3a and 3b illustrate. Alternatively, the at least two sides may comprise two sides which are not opposite to each other, or they may comprise three or four sides of the rotor.

The flexible suspenders 38 may be flexible in the vertical direction (z), so that they allow the rotor part 34 to move in a vertical direction with respect to the stator parts 37. Alternatively, the flexible suspenders 38 may be flexible in one or more horizontal directions (x and/or y), so that they allow the rotor part 34 to move in a horizontal direction. Another alternative is that the flexible suspenders are flexible in all three directions (x,y,z) and allow movement in all of these directions.

## Claims

1. A MEMS component which is an accelerometer or a gyroscope, the MEMS component comprising a silicon handle wafer (11, 21, 31) with a top surface (112) which defines a horizontal plane, whereby the top surface also defines a vertical direction which is perpendicular to the horizontal plane, and the MEMS component further comprises a silicon device wafer (12, 22, 32) with a bottom surface (122) and a top surface (121),
and the handle wafer comprises a cavity (13, 23, 33) which is delimited by a cavity floor (131) which is recessed in the vertical direction from the top surface of the handle wafer,
and the device wafer comprises a fixed stator part and a mobile rotor part (14, 24, 34), wherein the mobile rotor part has a rotor bottom surface (141) and a rotor top surface (142), and the mobile rotor part is above the cavity floor, **characterized in that** the MEMS component comprises a bottom coating layer (151, 152), which covers at least a part of the rotor bottom surface, and the density of the material in the bottom coating layer is greater than 5 g/cm³.

2. A MEMS component according to claim 1, wherein the MEMS component also comprises a top coating layer (252) which covers at least a part of the rotor top surface.

3. A MEMS component according to claim 2, wherein the material of the bottom coating layer is the same as the material of the top coating layer.

4. A MEMS component according to claim 3, wherein the vertical thickness of the top coating layer is substantially equal to the vertical thickness of the bottom coating layer, and the area covered by the bottom coating layer on the rotor bottom surface is substantially aligned in the vertical direction with the area covered by the top coating layer on the rotor top surface.

5. A method for manufacturing a MEMS component which is an accelerometer or a gyroscope, the method comprising the steps of
- forming a cavity (13) on a top surface (112) of a silicon handle wafer (11)
- bonding a bottom surface (122) of a silicon device wafer (12) onto the top surface of the handle wafer so that the device wafer covers the cavity,
- forming microelectromechanical structures (14, 24, 34) comprising a fixed stator part and a mobile rotor part in the device wafer, wherein the mobile rotor part has a rotor bottom surface (141) and a rotor top surface (142), and the mobile rotor part is suspended from the fixed stator part above the cavity,
**characterized in that** the method further comprises the step of:
- depositing a bottom coating layer (151) on at least a part of the rotor bottom surface (122) before the device wafer is bonded to the handle wafer, wherein the density of the material in the bottom coating layer is greater than 5 g/cm³.

6. A method according to claim 5, wherein the method further comprises the step of depositing a top coating layer (252) on at least a part of the rotor top surface.

7. A method according to claim 6, wherein the material of the bottom coating layer is the same as the material of the top coating layer.

8. A method according to claim 7, wherein the thickness of the top coating layer is substantially equal to the thickness of the bottom coating layer and the area covered by the bottom coating layer on the rotor bottom surface is substantially aligned in the vertical direction with the area covered by the top coating layer on the rotor top surface.

## Patentansprüche

1. MEMS-Komponente, die ein Beschleunigungsmesser oder ein Gyroskop ist, wobei die MEMS-Komponente einen Silicium-Trägerwafer (11, 21, 31) mit einer eine horizontale Ebene definierenden Oberseite (112) umfasst, wobei die Oberseite auch eine vertikale Richtung definiert, die rechtwinklig zur horizontalen Ebene ist, und die MEMS-Komponente ferner einen Silicium-Bauelementwafer (12, 22, 32) mit einer Unterseite (122) und einer Oberseite (121) umfasst,
und der Trägerwafer einen Hohlraum (13, 23, 33) umfasst, der durch einen Hohlraumboden (131) abgegrenzt ist, der in der vertikalen Richtung ausgehend von der Oberseite des Trägerwafers eingetieft ist,
und der Bauelementwafer einen feststehenden Statorteil und einen beweglichen Rotorteil (14, 24, 34) umfasst, wobei der bewegliche Rotorteil eine Rotor-Unterseite (141) und eine Rotor-Oberseite (142) aufweist und der bewegliche Rotorteil oberhalb des Hohlraumbodens liegt,
**gekennzeichnet dadurch, dass**
die MEMS-Komponente eine untere Beschichtungsschicht (151, 152) umfasst, die mindestens einen Teil der Rotor-Unterseite bedeckt, wobei die Dichte des Materials in der unteren Beschichtungsschicht größer als 5 g/cm³ ist.

2. MEMS-Komponente nach Anspruch 1, wobei die MEMS-Komponente auch eine obere Beschichtungsschicht (252) umfasst, die mindestens einen Teil der Rotor-Oberseite bedeckt.

3. MEMS-Komponente nach Anspruch 2, wobei das Material der unteren Beschichtungsschicht das gleiche wie das Material der oberen Beschichtungsschicht ist.

4. MEMS-Komponente nach Anspruch 3, wobei die vertikale Dicke der oberen Beschichtungsschicht im Wesentlichen gleich der vertikalen Dicke der unteren Beschichtungsschicht ist, und der von der unteren Beschichtungsschicht bedeckte Bereich auf der Rotor-Unterseite in vertikaler Richtung im Wesentlichen mit dem von der oberen Beschichtungsschicht bedeckten Bereich auf der Rotor-Oberseite fluchtet.

5. Verfahren zur Herstellung einer MEMS-Komponente, die ein Beschleunigungsmesser oder ein Gyroskop ist, wobei das Verfahren die Schritte umfasst:
- Ausbilden eines Hohlraums (13) auf einer Oberseite (112) eines Silicium-Trägerwafers (11),
- Bonden einer Unterseite (122) eines Silicium-Bauelementwafers (12) mit der Oberseite des Trägerwafers dergestalt, dass der Bauelementwafer den Hohlraum bedeckt,
- Ausbilden von mikroelektromechanischen Strukturen (14, 24, 34), die einen feststehenden Statorteil und einen beweglichen Rotorteil umfassen, im Bauelementwafer, wobei der bewegliche Rotorteil eine Rotor-Unterseite (141) und eine Rotor-Oberseite (142) aufweist und der bewegliche Rotorteil oberhalb des Hohlraums am feststehenden Statorteil aufgehängt ist,
**gekennzeichnet dadurch, dass** das Verfahren ferner den Schritt umfasst:
- Abscheiden einer unteren Beschichtungsschicht (151) auf mindestens einen Teil der Rotor-Unterseite (122), bevor der Bauelementwafer mit dem Trägerwafer gebondet wird, wobei die Dichte des Materials in der unteren Beschichtungsschicht größer als 5 g/cm³ ist.

6. Verfahren nach Anspruch 5, wobei das Verfahren ferner den Schritt umfasst: Abscheiden einer oberen Beschichtungsschicht (252) auf mindestens einen Teil der Rotor-Oberseite.

7. Verfahren nach Anspruch 6, wobei das Material der unteren Beschichtungsschicht das gleiche wie das Material der oberen Beschichtungsschicht ist.

8. Verfahren nach Anspruch 7, wobei die Dicke der oberen Beschichtungsschicht im Wesentlichen gleich der Dicke der unteren Beschichtungsschicht ist und der von der unteren Beschichtungsschicht bedeckte Bereich auf der Rotor-Unterseite in vertikaler Richtung im Wesentlichen mit dem von der oberen Beschichtungsschicht bedeckten Bereich auf der Rotor-Oberseite gefluchtet ist.

## Revendications

1. Composant MEMS, qui est un accéléromètre ou un gyroscope, ledit composant MEMS comprenant une tranche de support en silicium (11, 21 31) avec une face supérieure (122) qui définit un plan horizontal, dans lequel la face supérieure définit également une direction verticale perpendiculaire au plan horizontal, et le composant MEMS comprend également une tranche de dispositif en silicium (12, 22, 32) avec une face inférieure (122) et une face supérieure (121),
et la tranche de support comprend une cavité (13, 23, 33) qui est délimitée par un fond de cavité (131) enfoncé dans la direction verticale à partir de la face supérieure de la tranche de support,
et la tranche de dispositif comprend une partie statorique fixe et une partie rotorique mobile (14, 24, 34), ladite partie rotorique mobile comprenant une surface rotorique inférieure (141) et une surface rotorique supérieure (142) et ladite partie rotorique mobile étant située au-dessus du fond de cavité,
**caractérisé en ce que**
le composant MEMS comprend une couche de revêtement inférieure (151, 152) qui recouvre au moins une partie de la surface rotorique inférieure, et
la densité du matériau dans la couche de revêtement inférieure est supérieure à 5 g/cm³.

2. Composant MEMS selon la revendication 1, dans lequel le composant MEMS comprend également une couche de revêtement supérieure (252) qui recouvre au moins une partie de la surface rotorique supérieure.

3. Composant MEMS selon la revendication 2, dans lequel le matériau de la couche de revêtement inférieure est le même que le matériau de la couche de revêtement supérieure.

4. Composant MEMS selon la revendication 3, dans lequel l'épaisseur verticale de la couche de revêtement supérieure est essentiellement égale à l'épaisseur verticale de la couche de revêtement inférieure, et la zone recouverte par la couche de revêtement inférieure sur la surface rotorique inférieure est essentiellement alignée dans la direction verticale avec la zone recouverte par la couche de revêtement supérieure sur la surface rotorique supérieure.

5. Procédé de fabrication d'un composant MEMS, qui est un accéléromètre ou un gyroscope, ledit procédé comprenant les étapes consistant à :
- former une cavité (13) sur une face supérieure (112) d'une tranche de support en silicium (11),
- lier une face inférieure (122) d'une tranche de dispositif en silicium (12) à la face supérieure de la tranche de support de telle sorte que la tranche de dispositif recouvre la cavité,
- former des structures microélectromécaniques (14, 24, 34) comprenant une partie statorique fixe et une partie rotorique mobile dans la tranche de dispositif, ladite partie rotorique mobile comprenant une surface rotorique inférieure (141) et une surface rotorique supérieure (142) et ladite partie rotorique mobile étant suspendue à la partie statorique fixe au-dessus de la cavité,
**caractérisé en ce que** le procédé comprend également l'étape consistant à :
- déposer une couche de revêtement inférieure (151) sur au moins une partie de la surface rotorique inférieure (122) avant que la tranche de dispositif soit liée à la tranche de support, la densité du matériau dans la couche de revêtement inférieure étant supérieure à 5 g/cm³.

6. Procédé selon la revendication 5, dans lequel le procédé comprend également l'étape consistant à déposer une couche de revêtement supérieure (252) sur au moins une partie de la surface rotorique supérieure.

7. Procédé selon la revendication 6, dans lequel le matériau de la couche de revêtement inférieure est le même que le matériau de la couche de revêtement supérieure.

8. Procédé selon la revendication 7, dans lequel l'épaisseur de la couche de revêtement supérieure est essentiellement égale à l'épaisseur de la couche de revêtement inférieure et la zone recouverte par la couche de revêtement inférieure sur la surface rotorique inférieure est essentiellement alignée dans la direction verticale avec la zone recouverte par la couche de revêtement supérieure sur la surface rotorique supérieure.
